Europäisches Patentamt

(19) European Patent Office

Office européen des brevets

(11) Publication number: **0 220 542 B1**

(12) **EUROPEAN PATENT SPECIFICATION**

(45) Date of publication of patent specification: **27.05.92** (51) Int. Cl.⁵: **H01L 21/76**, H01L 21/308

(21) Application number: **86113734.7**

(22) Date of filing: **03.10.86**

(54) **Dielectric-filled-groove isolation structures for semiconductor devices.**

(30) Priority: **05.10.85 JP 222596/85**

(43) Date of publication of application:
**06.05.87 Bulletin 87/19**

(45) Publication of the grant of the patent:
**27.05.92 Bulletin 92/22**

(84) Designated Contracting States:
**DE FR GB**

(56) References cited:

IBM TECHNICAL DISCLOSURE BULLETIN, vol.
24, no. 9, February 1982, pages 4744-4745,
New York, US; C.G. JAMBOTKAR: "Method
for forming recessed oxide isolation is-
lands"

IBM TECHNICAL DISCLOSURE BULLETIN, vol.
19, no. 12, May 1977, pages 4596-4597, New
York, US; I. ANTIPOV: "Minimizing "Bird's
beak" when forming recessed dielectric iso-
lation"

IBM TECHNICAL DISCLOSURE BULLETIN, vol.
24, no. 7A, December 1981, pages 3389-3392,
New York, US; A.P. HO et al.: "Self-aligned
"Framed" recessed-oxide-isolation process"

INTERNATIONAL ELECTRON DEVICES MEET-
ING 1982, San Francisco, 13th-15th Decem-
ber 1982, pages 62-65, IEEE, New York, US; A.
HAYASAKA et al.: U-Groove isolation tech-
nique for high speed bipolar VLSI's"

(73) Proprietor: **FUJITSU LIMITED**
**1015, Kamikodanaka Nakahara-ku**
**Kawasaki-shi Kanagawa 211(JP)**

(72) Inventor: **Fukushima, Toshitaka Fujitsu Ltd.**
**Patent DepT.**
**Kosugi Fujitsu Building 1812-10**
**Shimonumabe**
**Nakahara-ku Kawasaki-shi Kanagawa 211(JP)**

(74) Representative: **Sunderland, James Harry et al**
**HASELTINE LAKE & CO Hazlitt House 28**
**Southampton Buildings Chancery Lane**
**London WC2A 1AT(GB)**

## Description

The present invention relates to a method of producing a semiconducter device having a dielectric-filled-groove isolation structure.

With the progress of semiconductor technology towards higher integration densities, various methods of isolation have been introduced. A pn-junction isolation method has been utilized for a long time, but such a method requires that a comparatively large area of a substrate be devoted to an isolation region formed by this method. In order to increase integration density, a method of isolation involving the use of selective oxidation has been introduced; the method is known as LOCOS or Isoplanar and has been widely used.

In an effort to obtain still higher integration densities, a groove (sometimes called a trench, depending on its shape) isolation structure buried or filled with dielectric material, has been introduced.

A method of isolation involving forming a groove and filling the groove with a dielectric material such as polysilicon (to obtain a dielectric-filled-groove isolation structure) is well known. Different types of groove, of different shape, a V-shape type groove, a trench-type groove (having a comparatively great depth and comparatively narrow width), a combination groove-type, combining a V-shape and a deep trench, etc., can be provided. For simplicity, the first type mentioned above is called a V-groove, the second a U-groove, and the third a Y-groove.

A V-groove isolation structure is formed in a silicon substrate having a surface crystal index of orientation (100), utilizing wet etching in alkali solution, and a U-groove isolation structure is formed utilizing reactive ion etching. A U-groove isolation structure is suitable for providing a deeper groove than a V-groove isolation structure.

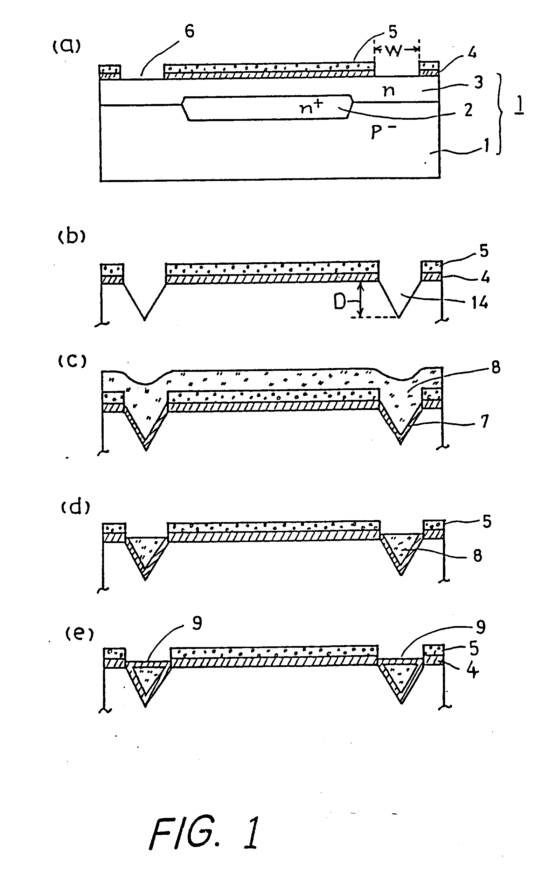

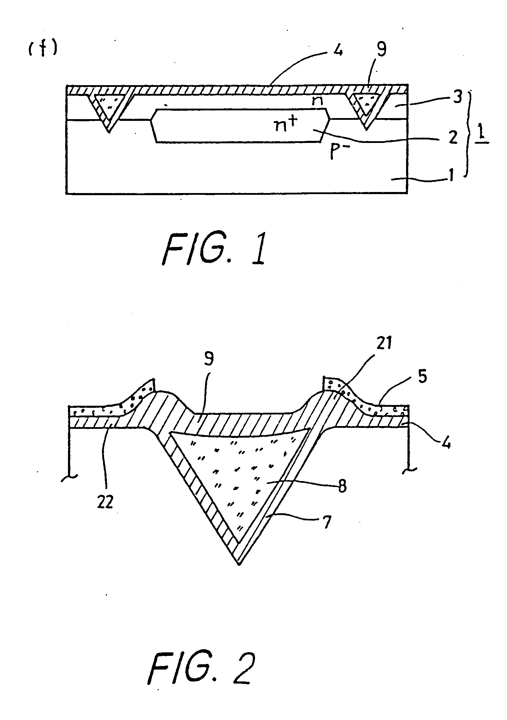

A previously proposed method of forming a V-groove isolation structure will be explained briefly with reference to Figs. 1(a) to 1(f).

Fig. 1(a) is a schematic cross-sectional view of a substrate 1, comprising a $p^-$-type silicon base layer 1, an $n^+$-type silicon buried layer 2, and an n-type silicon epitaxial layer 3, formed by conventional bipolar techniques. The substrate 1 has a surface index of orientation (100). A silicon oxide ($SiO_2$) layer 4 and a silicon nitride ($Si_3N_4$) layer 5 are formed on the silicon epitaxial layer 3. Both layers 4 and 5, in a region corresponding to an upper area of a V-groove subsequently to be formed, are selectively etched and removed.

When a substrate having a crystal orientation as mentioned above is used, anisotropic etching is carried out, using an alkali solution such as potassium hydroxide (KOH), to form a V-groove, using silicon oxide layer 4 and silicon nitride layer 5 as etch masks. A groove 14, V-shaped in cross section, is then formed as shown in Fig. 1(b).

When W in Fig. 1(a) is taken as the width of a V-groove, the depth D of the V-groove is determined by the following relationship:

$$D = (1/2) \times W \times \tan (54.7°) \approx 0.7W.$$

This illustrates that the depth of the V-groove is less than the width W of the isolation region.

Fig. 1(c) illustrates that a silicon oxide layer 7 having a thickness of about 500 nm (5,000 Angstroms) is grown on the inside surface of the V-groove by a thermal oxidation process, and thereafter polycrystalline silicon (polysilicon) 8 is grown over the whole surface of the substrate 1, the V-groove being filled with polysilicon.

The polysilicon 8 is polished mechanically and chemically using silicon nitride layer 5 as a stopper, as illustrated in Fig. 1(d).

The surface of the polysilicon 8 filling the V-groove is then thermally oxidized to form a silicon oxide layer 9 of 500 to 800 nm (5,000 to 8,000 Angstrom) thickness, as shown in Fig. 1(e).

After removal of the silicon nitride layer 5, the substrate, having a (nominally) planar surface covered with silicon oxide layers 4 and 9, and having a V-groove isolation structure, is provided as shown in Fig. 1(f).

The method described above relates to the formation of a V-groove isolation structure. When a deep isolation groove, in the form of a narrow vertical trench (U-groove) is required, anisotropic etching is carried out using reactive ion etching employing a mixed gas of carbon tetrachloride ($CCL_4$) and oxygen ($O_2$). For forming such a U-groove isolation structure a surface crystal orientation of (100) is not necessary for the substrate. Other processes, excepting the etching process as mentioned above, are the same as those employed for forming a V-groove isolation structure as described above.

The methods of forming grooves as mentioned above involve a significant problem in the formation of so-called bird's beak and bird's head structures, which problem limits increase in integration density of semiconductor devices which can be obtained using groove isolation structures.

Fig. 2 is an enlarged cross-sectional view illustrating a V-groove isolation structure formed by the method illustrated in Fig. 1, just before the step in which silicon nitride layer 5 is removed. Three silicon oxide layers: first-formed layer 4, second-formed layer 7 inside the V-groove, and third-formed layer 9 of (oxidised) polysilicon join together at an edge or peripheral region of the V-groove on the substrate.

At the join the thickness of the silicon oxide is increased and the oxide projects vertically, forming a so-called bird's head 21. The thickness of the bird's head decreases away from the groove, under silicon nitride layer 5, forming a so-called bird's beak 22.

These features result from the fact that in the oxidation of silicon the oxide formed occupies a volume greater than that of the initially-present silicon, the increase in volume being approximately the same as the volume of the initially-present silicon. Moreover, the oxidation of silicon has different characteristics depending on the material being oxidised (such as substrate silicon or polysilicon) and the oxidation conditions. Silicon and polysilicon, which are present in the peripheral region of the V-groove, are most often subject to oxidation processes, and volume increases both vertically and laterally are manifest as a result of the oxidation, and shape is deformed irregularly. A substantially similar effect is present when forming a U-groove isolation structure using the method mentioned above.

As explained above, the previously proposed method of forming dielectric-filled-groove isolation structures has a significant drawback in that the flatness of the substrate surface is reduced, and a substantial increase of effective width of the groove isolation is present, which results in a requirement for greater allowances in subsequent mask alignment processes, limiting integration density and potentially involving poor quality of active elements caused in particular by wiring layers having steep steps on the grooves in a semiconductor device.

IEDM Technical Digest, International Electron Devices Meeting 1982, San Francisco, CA, December 13-15, pages 62-65, and IBM Technical Disclosure Bulletin, Vol. 24, No. 9, February 1989, pages 4744-5, each disclose a method of producing a semiconductor device having a dielectric-filled-groove isolation structure, in which method silicon oxide and silicon nitride layers are formed on a silicon substrate and etched selectively to provide a mask for etching an isolation groove in the silicon substrate. In the IEDM method, silicon oxide is formed inside the groove, the groove is filled with dielectric material and the filling of the groove is levelled with the surface of the substrate in which the groove is formed.

According to the present invention there is provided a method of producing a semiconductor device having a dielectric-filled-groove isolation structure, in which method silicon oxide and silicon nitride layers are formed on a silicon substrate and etched selectively to provide a mask for etching an isolation groove in the silicon substrate, silicon oxide is formed inside the groove, the groove is filled with dielectric material and the filling of the groove is levelled with the surface of the substrate in which the groove is formed, the method being characterised by the steps of:-

(a) forming a first silicon oxide layer on the substrate;

(b) selectively removing the first silicon oxide layer from above a specified region of the substrate, the specified region surrounding a region of the substrate in which the isolation groove is to be formed and the specified region having an extent sufficient for preventing a spread of silicon oxidation in subsequent processes;

(c) forming a silicon nitride layer on the first silicon layer and the substrate where exposed in step;

(d) etching selectively both the silicon nitride layer and the first silicon oxide layer, so that the substrate surface corresponding to the region in which the isolation groove is to be formed is exposed, leaving the silicon nitride layer over the specified region, with overhanging eaves protruding over the region in which the isolation groove is to be formed, and above an active region of the substrate;

(e) etching the exposed substrate to form the isolation groove, using the silicon nitride layer as a mask;

(f) forming a further silicon oxide layer, inside the groove;

(g) filling the groove with dielectric material; and

(h) removing excess dielectric material for levelling the substrate surface, and forming another silicon oxide layer on the dielectric material.

An embodiment of the present invention can provide a method of forming a dielectric-filled-groove isolation structure without, or with a mitigation of, attendant bird's head and bird's beak problems.

An embodiment of the present invention can provide a method of forming a dielectric-filled-groove isolation structure self-aligned with a mask process utilized in suppressing bird's beak or bird's head problems.

An embodiment of the present invention can provide a method in which a substrate is provided with a flat surface around groove isolation regions, hence avoiding factors tending to reduce quality of semiconductor devices.

An embodiment of the invention can provide a method enabling the production of a semi conductor device having a higher integration density.

An embodiment of the present invention can provide a method applicable for an integrated circuit which requires a high integration density, wherein the problem of so-called bird's beak or bird's head in forming a groove isolation structure, which limits integration density, is suppressed. The method can moreover allow formation of an isolation groove by a so-called self-alignment method.

As explained above, in a previously proposed method, bird's head or bird's beaks formed as a result of an excess oxidation of silicon material cause vertical and lateral swelling around a peripheral region of a groove on a substrate.

An embodiment of the present invention can provide a means of preventing that the substrate surface around such a peripheral region suffers from such excess oxidation.

This is achieved in a method embodying the present invention by (in comparison with the previously proposed method mentioned above) removing a first silicon oxide layer (4), deposited at an early stage as a protective mask, at least from above a region peripheral to an isolation groove, and depositing a silicon nitride layer directly on the silicon substrate to act as a protective mask for preventing oxidation of the substrate. Therefore the surface region of the substrate which, in the previously proposed method mentioned above, has suffered the formation of bird's beak or bird's head structures, is covered by a silicon nitride layer only, forming a protective mask, and thus this region does not suffer any substantial oxidation, swelling of the substrate in this region is prevented, and surface flatness is maintained.

Moreover, the process of forming an isolation groove can be carried out by a process in self-alignment with a window formed in the first silicon oxide layer by the removal operation mentioned above.

Groove isolation structures have distinctive features depending on the shape of groove, e.g. V-shape. A V-groove is characteristically a shallow groove: the depth of the groove being automatically controlled, and the process for forming the groove being relatively easy. A U-groove is characteristically deep and narrow, suitable for high integration density applications, but relatively difficult to form.

A combination type, rather resembling a boldfaced Y character in cross-section (briefly referred to as a Y-groove) is a compromise structure between a V-groove and a U-groove. A Y-groove is effective and useful in high integration density applications and it is easy to fill up the groove. A substrate having a crystal orientation (100) is used, an upper portion of the groove having sloped side walls is first formed by anisotropic wet etching, and a lower portion, relatively deep, narrow and with vertical side walls, is subsequently formed by reactive ion etching.

Methods embodying the present invention can be used to form self-aligned isolation grooves, avoiding the growth of bird's beak or bird's head structures, for example of a Y-groove type, by processes involving removing a (part of a) silicon oxide layer and covering a thereby exposed surface region of the substrate with a silicon nitride layer which corresponds to a specified region surrounding an area where an isolation groove is to be formed.

Reference is made, by way of example, to the accompanying drawings, in which:-

Figs. 1(a) to 1(f) are respective cross-sectional views illustrating steps in the formation of a dielectric-filled V-groove structure in accordance with a previously proposed method;

Fig. 2 shows a cross-sectional view of a V-groove formed by the method of Figs. 1, illustrating bird's head and bird's beak silicon oxide structures around a groove region;

Figs. 3(a) to 3(j) are respective cross-sectional views illustrating steps in the formation of a dielectric-filled Y-groove isolation structure in accordance with a method embodying the present invention.

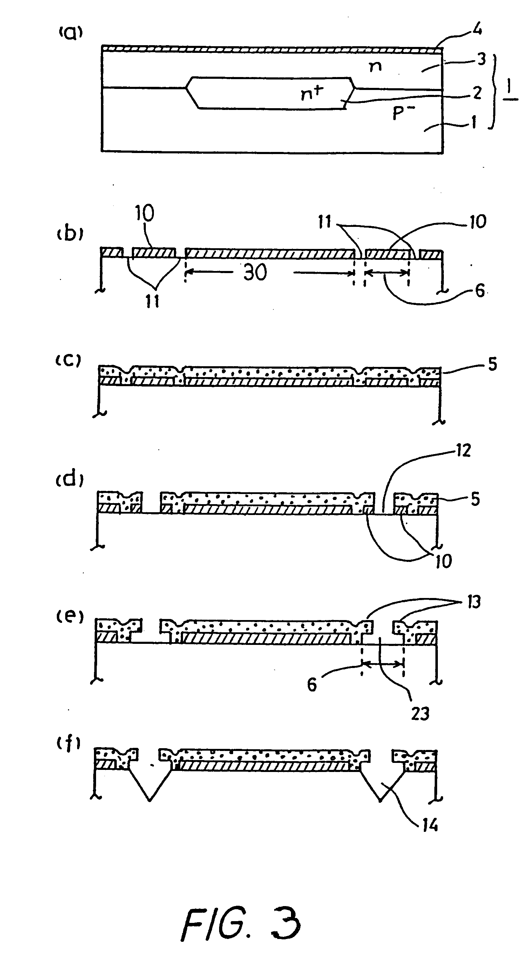

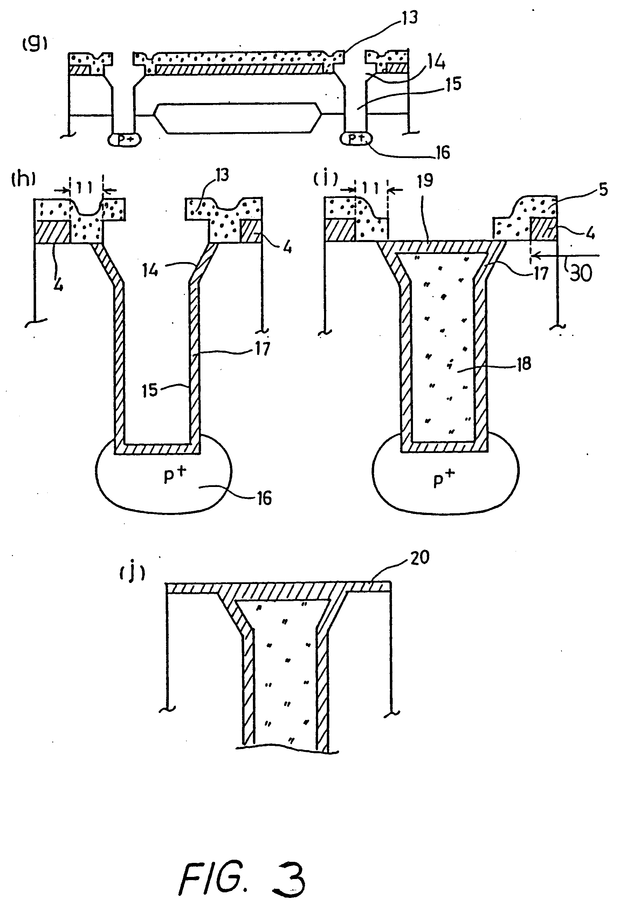

A method embodying the present invention is described with reference to Figs. 3(a) to 3(j). In this case a Y-groove isolation structure is provided.

A Y-groove isolation structure has a structure with a V-shaped upper portion, and a parallel-walled trench shaped lower portion The following alphabetically labelled steps correspond to similarly labelled Figs. 3(a) to 3(j).

(a) A $p^-$-type silicon base layer 1 having crystal orientation (100), an $n^+$-type silicon buried layer 2, and n-type silicon epitaxial layer 3 are comprised in a substrate 1, and a silicon oxide layer ($SiO_2$) 4 having a thickness of 50 to 100 nm (500 to 1,000 nm Angstrom) is formed on the substrate 1 as shown in Fig. 3(a). This step is the same as is employed in a bipolar process.

(b) A portion of the silicon oxide layer on a surface area corresponding to a specified region 11, which surrounds a region 6 in which a groove is subsequently to be formed for isolation and which has a width of not less in substance than 300 nm (3,000 Angstrom) [300 to 500 nm (3,000 to 5,000 Angstrom) is preferable], is removed by photolithography technology, leaving a silicon oxide layer 10 just above the region 6 designated for groove isolation and above an active region 30.

(c) A silicon nitride layer ($Si_3N_4$) 5 of 150 to 200 nm (1,500 to 2,000 Angstrom) thickness is then deposited as shown.

(d) The silicon nitride layer 5 and silicon oxide layer 10 are partially removed, from a region 12 which corresponds to an area designated for the subsequent formation of a U-groove.

(e) Remaining silicon oxide 10 (above region 6) is etched away by a wet method using silicon nitride layer 5 as a mask. A window 23 having overhanging eaves 13 of silicon nitride is thus formed.

(f) The exposed substrate region 6 in window 23 is subject to anisotropic etching using an alkali solution such as potassium hydroxide (KOH), whereby a V-groove 14 is formed.

(g) The substrate is then subject to anisotropic etching using reactive ion etching in carbon tetrachloride ($CCl_4$) and oxygen ($O_2$) atmosphere using the overhanging eaves of silicon nitride 13 as a mask, and a U-groove 15 is formed under the V-shaped groove 14. Boron, for example, is then ion implanted to form a channel stopper 16.

(h) Inside surfaces of the grooves 14 and 15 are thermally oxidized, and silicon oxide layers 17 having a thickness of 300 to 800 nm (3,000 to 8,000 Angstrom) are formed. An enlarged cross-sectional view of one groove is shown in Fig. 4-(h).

(i) The eaves 13 of silicon nitride are removed and polysilicon 18 is grown on the substrate filling up the groove. Thereafter the surface of polysilicon is polished mechanically and chemically, until the surface of silicon nitride layer 5 is exposed and polysilicon (in the groove) is removed to a level of the surface of the substrate. The surface of the polysilicon filling the groove is oxidized forming a silicon oxide layer 19 of 500 to 800 nm (5,000 to 8,000 Angstrom) thickness.

(j) The entire silicon nitride layer 5 on the substrate, and silicon oxide layer 4 on active region 30, are removed, and then new silicon oxide film 20 having 100 nm (1,000 Angstrom) thickness is formed thereon. Thus a Y-groove isolation structure filled with dielectric is formed.

In the above steps (h) and (i), involving oxidation in relation to the Y-groove, silicon oxide layer 4 is separated from silicon oxide layers 17 and 19 of the groove by the specified region 11 surrounding the groove, and this specified region is covered with a protective layer of silicon nitride. Therefore the oxidation processes in steps (h) and (i) do not bring about a volume growth of silicon oxide resulting in formation of a bird's head or a bird's beak.

Moreover, the top portion 14 of the isolation groove having a V-shape and constituting an upper portion of the Y-groove isolation structure, is formed self-aligned with the mask process applied in step (b), which defines the specified region 11. Therefore even if the lower, U-shape, portion of the Y-groove, which is formed using another mask process, has a deviation from an aligned position, the top V-shaped portion of the isolation region in the substrate is self-aligned automatically, having a very small allowance.

In the embodiment of the present invention above described, the generation of bird's beak or bird's head structures is suppressed and an isolation groove is formed in essentially a self-aligned manner. This brings about the effect of decreasing the width required for an isolation region, the location of isolation region being more precisely definable, and thus offers the possibility of increased integration density of semiconductor devices.

In the manufacture of an integrated circuit, the provision of isolation between adjacent active elements on a substrate of the circuit plays an important role. Dielectric-filled-groove isolation is a possible method of isolation offering potentially high integration density. Previously, however, the problems of bird's head or bird's beak structures around a groove isolation region have restricted integration density and reduced substrate flatness. The method of forming an isolation groove in accordance with an embodiment of the present invention provides that a silicon oxide (silicon dioxide) layer on a specified region of the substrate, surrounding an isolation groove region, is removed and a silicon nitride layer deposited directly on the substrate, the isolation groove is formed self-aligned with the process for removal of the silicon oxide layer. This suppresses the problems above, resulting in the potential for achieving a higher density of integration and better substrate flatness.

## Claims

1. A method of producing a semiconductor device having a dielectric-filled-groove isolation structure, in which method silicon oxide (4) and silicon nitride (5) layers are formed on a silicon substrate (1) and etched selectively to provide a mask for etching an isolation groove (14) in the silicon substrate (1), silicon oxide (17) is formed inside the groove (14), the groove is filled with dielectric material (18) and the filling of the groove is levelled with the surface of the substrate in which the groove is formed, the method being characterised by the steps of:-

   (a) forming a first silicon oxide layer (4) on the substrate (1);

   (b) selectively removing the first silicon oxide layer (4) from above a specified region (11) of the substrate (1), the specified region (11) surrounding a region (6) of the substrate (1) in which the isolation groove (14) is to be formed and the specified region (11) having an extent sufficient for preventing a spread of silicon oxidation in subsequent processes;

   (c) forming a silicon nitride layer (5) on the first silicon layer (4) and the substrate where exposed in step (b);

   (d) etching selectively both the silicon nitride layer (5) and the first silicon oxide layer (4), so that the substrate surface (12) corresponding to the region (6) in which the isolation groove (14) is to be formed is exposed, leaving the silicon nitride layer (5) over the specified region (11), with overhanging eaves (13) protruding over the region (6) in which the isolation groove (14) is to be formed, and above an active region (30) of the substrate (1);

(e) etching the exposed substrate (1) to form the isolation groove (14), using the silicon nitride layer (5) as a mask;

(f) forming a further silicon oxide layer (17), inside the groove (14);

(g) filling the groove with dielectric material (18); and

(h) removing excess dielectric material for levelling the substrate surface, and forming another silicon oxide layer (20) on the dielectric material.

2. A method according to claim 1, wherein the substrate (1) is provided with a surface crystal orientation <100>, and the etching of step (e) is anisotropic wet etching in alkali solution, whereby a V-shaped isolation groove is formed.

3. A method according to claim 1, wherein the etching of step (e) is anisotropic reactive ion etching, whereby a U-shaped isolation groove is formed.

4. A method according to claim 1, wherein the substrate (1) is provided with a surface crystal orientation <100>, and the etching of step (e) comprises, first, wet etching in alkali solution and, second, anisotropic reactive sputter etching, whereby a Y-shaped isolation groove is formed.

5. A method according to claim 3 or 4, wherein the isolation groove (14) penetrates through a silicon epitaxial layer (3) and reaches a silicon base layer (1) therebeneath, both the latter layers being constituents of the substrate.

6. A method as claimed in any preceding claim, wherein the specified region (11) has a width of at least substantially 300 nm (3,000 Angstrom).

**Revendications**

1. Procédé de fabrication d'un dispositif à semiconducteur ayant une structure d'isolement à gorge remplie d'un diélectrique, dans lequel des couches d'oxyde de silicium (4) et de nitrure de silicium (5) sont formées sur un substrat de silicium (1) et retirées sélectivement par attaque avec un masque d'attaque d'une gorge d'isolement (14) dans le substrat de silicium (1), de l'oxyde de silicium (17) est formé dans la gorge (14), la gorge est remplie d'un matériau diélectrique (18) et le remplissage de la gorge est nivelé au niveau de la surface du substrat dans lequel est formée la gorge, le procédé étant caractérisé par les étapes suivantes :

(a) la formation d'une première couche (4) d'oxyde de silicium sur le substrat (1),

(b) l'enlèvement sélectif de la première couche (4) de l'oxyde de silicium au-dessus d'une région spécifiée (11) du substrat (1), la région spécifiée (11) entourant une région (6) du substrat (1) dans laquelle la gorge d'isolement (14) doit être formée et la région spécifiée (11) ayant une étendue suffisante pour qu'elle empêche un étalement de l'oxydation du silicium dans les opérations ultérieures,

(c) la formation d'une couche (5) de nitrure de silicium sur la première couche (4) de silicium et le substrat, aux emplacements exposés dans l'étape (b),

(d) l'attaque sélective à la fois de la couche (5) de nitrure de silicium et de la première couche (4) d'oxyde de silicium, afin que la surface (12) du substrat correspondant à la région (6) dans laquelle la gorge d'isolement (14) doit être formée soit exposée, la couche (5) de nitrure de silicium restant sur la région spécifiée (11) avec des avancées (13) en surplomb qui dépassent au-dessus de la région (6) dans laquelle la gorge d'isolement (14) doit être formée, au-dessus d'une région active (30) du substrat (1),

(e) l'attaque du substrat exposé (1) pour la formation de la gorge d'isolement (14) avec la couche (5) de nitrure de silicium comme masque,

(f) la formation d'une couche supplémentaire (17) d'oxyde de silicium à l'intérieur de la gorge (14),

(g) le remplissage de la gorge par un matériau diélectrique (18), et

(h) l'enlèvement du matériau diélectrique en excès afin que la surface du substrat soit mise à niveau, et la formation d'une autre couche (20) d'oxyde de silicium sur le matériau diélectrique.

2. Procédé selon la revendication 1, dans lequel le substrat (1) a une orientation cristalline en surface <100>, et l'attaque de l'étape (e) est une attaque anisotrope de type humide dans une solution alcaline, si bien qu'une gorge d'isolement en V se forme.

3.  Procédé selon la revendication 1, dans lequel l'attaque de l'étape (e) est une attaque anisotrope par des ions réactifs, si bien qu'une gorge d'isolement en U se forme.

4.  Procédé selon la revendication 1, dans lequel le substrat (1) a une orientation cristalline superficielle <100>, et l'attaque de l'étape (e) comprend d'abord une attaque de type humide dans une solution alcaline puis une attaque anisotrope par pulvérisation réactive, si bien qu'une gorge d'isolement en Y se forme.

5.  Procédé selon la revendication 3 ou 4, dans lequel la gorge d'isolement (14) traverse une couche épitaxiale (3) de silicium et atteint une couche de base (1) de silicium placée au-dessous, ces deux dernières couches étant les constituants du substrat.

6.  Procédé selon l'une quelconque des revendications précédentes, dans lequel la région spécifiée (11) a une largeur au moins égale à 300 nm environ (3 000 Å).

**Patentansprüche**

1.  Verfahren zur Herstellung einer Halbleiter-vorrichtung, die eine Isolationsstruktur mit einer mit einem Dielektrikum gefüllte Nut hat, bei welchem Verfahren Siliziumoxyd-(4) und Sili-umnitridschichten (5) auf einem Siliziumsub-strat (1) gebildet und selektiv geätzt werden, um eine Maske zum Ätzen einer Isolationsnut (14) in dem Siliziumsubstrat (1) vorzusehen, wobei Siliziumoxyd (17) innerhalb der Nut (14) gebildet wird, die Nut mit dielektrischem Material (18) gefüllt wird und die Füllung der Nut mit der Oberfläche des Substrates ausgepegelt wird, in welchem die Nut gebildet ist, welches Verfahren durch die folgenden Schritte gekennzeichnet ist:-

    (a) Bilden einer ersten Oxydschicht (4) auf dem Substrat (1),
    (b) selektives Entfernen der ersten Siliziumoxydschicht (4) von oberhalb eines spezifizierten Bereiches (11) auf dem Substrat (1), welcher spezifizierte Bereich (11) einen Bereich (6) des Substrats (1) umgibt, in welchem die Isolationsnut (14) gebildet werden soll und welcher spezifizierte Bereich (11) eine Ausdehnung hat, die ausreicht, um ein Ausbreiten der Siliziumoxidation bei den folgenden Verfahren zu verhindern;
    (c) Bilden einer Siliziumnitridschicht (5) auf der ersten Siliziumschicht (4) und dem Substrat, wo es bei dem Schritt (b) exponiert wurde;
(d) selektives Ätzen sowohl der Siliziumnitridschicht (5) als auch der ersten Siliziumoxydschicht (4), so daß die Substratoberfläche (12), die dem Bereich (6) entspricht, in dem die Isolationsnut (14) gebildet werden soll, exponiert wird, Lassen der Siliziumnitridschicht (5) über dem spezifizierten Bereich (11), mit überhängenden Vordächern (13), die über den Bereich (6) vorstehen, in dem die Isolationsnut (14) gebildet werden soll, und oberhalb eines aktiven Bereiches (30) des Substrates (1);
(e) Ätzen des exponierten Substrats (1), um die Isolationsnut (14) zu bilden, unter Verwendung der Siliziumnitridschicht (15) als eine Maske;
(f) Bilden einer weiteren Siliziumoxydschicht (17), innerhalb der Nut (14);
(g) Füllen der Nut mit dielektrischen Material (18); und
(h) Entfernen überschüssigen dielektrischen Materials zum Auspegeln der Substratoberfläche und Bilden einer anderen Siliziumoxydschicht (20) auf dem dielektrischen Material.

2.  Verfahren nach Anspruch 1, bei dem das Sub-strat (1) mit einer Oberflächenkristallorientie-rung <100> vorgesehen ist, und das Ätzen des Schrittes (e) ein anisotropes Feuchtätzen in Alkalilösung ist, wodurch eine V-förmige Isolationsnut gebildet wird.

3.  Verfahren nach Anspruch 1, bei dem das Ätzen des Schrittes (e) ein anisotropes reaktives Ionenätzen ist, wodurch eine U-förmige Isolationsnut gebildet wird.

4.  Verfahren nach Anspruch 1, bei dem das Sub-strat (1) mit einer Oberflächenkristallorientie-rung <100> versehen ist, und das Ätzen des Schrittes (e) erstens ein Feuchtätzen in einer Alkalilösung und zweitens ein anisotropes reaktives Sputter-Ätzen umfaßt, wodurch eine Y-förmige Isolationsnut gebildet wird.

5.  Verfahren nach Anspruch 3 oder 4, bei dem die Isolationsnut (14) eine epitaktische Siliziumschicht (3) durchdringt und eine Siliziumbasisschicht (1) darunter erreicht, wobei die letztgenannten Schichten Bestandteile des Substrates sind.

6.  Verfahren nach einem der vorhergehenden Ansprüche, bei dem der spezifizierte Bereich (11) eine Breite von wenigstens im wesentlichen 300 nm (3.000 Angstrom) hat.

FIG. 1

(f)

FIG. 1

FIG. 2

FIG. 3

(g)

(h)

(i)

(j)

# FIG. 3